# EUROPÄISCHE PATENTANMELDUNG

(11) **EP 0 534 253 A1**
(43) Veröffentlichungstag der Anmeldung: **31.03.1993**
(21) Anmeldenummer: 92115613.9
(22) Anmeldetag: 11.09.1992
(51) Int. Cl.: H05K 7/18, H02B 1/30

(54) **Metallschrank zur Aufnahme von elektrotechnischen Bauteilen mit einstellbarer Versteifungsvorrichtung**

(30) Priorität: 27.09.1991 DE 9112108 U
(71) Anmelder: SIEMENS AKTIENGESELLSCHAFT, D-80333 München (DE)
(72) Erfinder: Latussek, Hans-Peter, Dipl.-Ing., W-8501 Feucht (DE); Kosel, Thomas, Dipl.-Ing., W-8520 Erlangen (DE)

(57) **Zusammenfassung**

Die Versteifungsvorrichtung (2) weist ein erstes und zweites Winkelstrebenpaar auf. Deren Schenkel (61,62;71,72) verlaufen annähernd vom Zentrum (A) einer Seitenfläche (4,5) des Metallschrankes zu den oberen und unteren Eckpunkten (81,91;82,92). Die Winkelstrebenpaare sind über einen Spannverschluß (13;14, 15,16) annähernd im Zentrum (A) verspannbar. Erfindungsgemäß sind Mittel zur Längenanpassung (17) für die Schenkel (61,62; 71,72) vorgesehen. Diese sind ebenfalls annähernd im Zentrum (A) der Seitenfläche (4,5) im Bereich des Spannverschlusses (13;14, 15,16) in die Schenkel der Winkelstrebenpaare integriert.

## Beschreibung

Die Erfindung betrifft einen Metallschrank zur Aufnahme von elektrotechnischen Bauteilen, der an mindestens einer Seitenfläche eine Versteifungsvorrichtung aufweist.

Metallschränke zur Aufnahme von elektrotechnischen Bauteilen, insbesondere von so genannten Schalt- bzw. Elektronikschränken, weisen meist ein Rahmengestell mit großflächigen Seiten auf. Diese Seiten sind mit relativ dünnwandigen Metallblechen belegt. Zu deren Stabilisierung sind häufig Versteifungsvorrichtung vorgesehen, welche bevorzugt auf die Innenseiten des jeweiligen Abdeckbleches aufgelegt sind.

So ist z.B. aus dem Europäischen Patent mit der Veröffentlichungsnummer 0 298 305 eine Versteifungsvorrichtung für einen Elektronikschrank bekannt. Die dortige Vorrichtung betrifft insbesondere eine spezielle Ausführung eines Spannschlosses für die Versteifung einer in Form einer zweiflügigen Tür ausgebildeten Seitenfläche des Elektronikschrankes.

Desweiteren ist aus der Europäischen Patentanmeldung mit der Veröffentlichungsnummer 0 443 375 ein lösbarer Spannverschluß für eine Schaltschrank-Versteifungsvorrichtung bekannt. Dabei ist der Spannhebel zur Betätigung des Verschlusses so angeordnet, daß er in der von der Versteifungsvorrichtung gebildeten Ebene verschwenkbar ist.

Derartige Versteifungsvorrichtungen haben die Aufgabe, die Seitenflächen eines bevorzugt aus einem Rahmengestell mit aufgesetzten Abdeckplatten bestehenden Metallschrankes trotz dünnwandiger Ausführung der Abdeckplatten ausreichend zu stabilisieren. Dennoch darf die jeweilige Versteifungsvorrichtung auch dann, wenn die dazugehörige Seitenfläche eine Türfläche des Metallschrankes bildet, nicht vollständig starr sein. Vielmehr muß es z.B. auch bei einer leicht schrägen, d.h. einen geringfügig inneren Verzug im Metallschrank hervorrufenden Aufstellposition möglich sein, eine kipp- und klemmfreie Aufstellung des Schrankes bzw. Einstellung der Seiten- und Türflächen zu erreichen. Der Erfindung liegt somit die Aufgabe zugrunde, einen Metallschrank mit einer Versteifungsvorrichtung anzugeben, mit deren Hilfe auch Ungenauigkeiten bzw. Verwindungen ausgeglichen werden können, welche durch die Herstellung, Montage und/oder Auswahl der Aufstellposition des Metallschrankes hervorgerufen werden können.

Die Aufgabe wird gelöst mit dem im Anspruch 1 angegebenen Metallschrank. Vorteilhafte Ausführungsformen desselben sind in den Unteransprüchen angegeben.

Die Erfindung wird desweiteren an Hand eines, in den nachfolgend kurz angeführten Figuren dargestellten bevorzugten Ausführungsbeispieles näher erläutet. Dabei zeigt
- FIG 1: eine Draufsicht auf eine beispielhaft als zweiflügelige Tür ausgebildete und eine Versteifungsvorrichtung enthaltende Seitenfläche eines Metallschrankes, und
- FIG 2: eine vergrößerte Detailansicht des Zentrums der Seitenfläche von FIG 1 mit einem Spannverschluß und Mitteln zur Längenanpassung der Schenkel der Versteifungsvorrichtung.

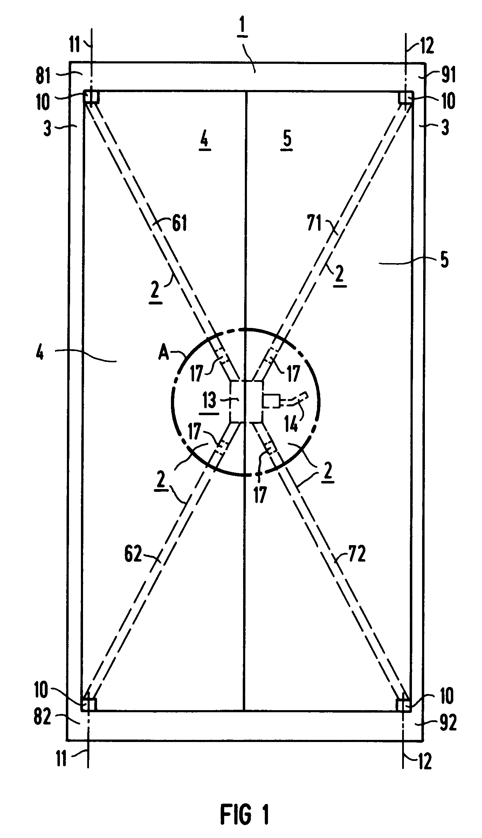

FIG 1 zeigt die Frontansicht eines beispielhaften Metallschrankes 1, welcher mit einer strichliert dargestellten Versteifungsvorrichtung 2 stabilisiert ist. Der Metallschrank 1 weist dabei beispielhaft ein Rahmengestell 3 auf, dessen Deck- und Seitenflächen mit bevorzugt dünnwandigen Abdeckblechen belegt sind. In FIG 1 ist beispielhaft die Vorderseite dargestellt, welche als eine zweiflügelige Tür mit einem linken und rechten Flügel 4, 5 ausgebildet ist. Die erfindungsgemäße Versteifungsvorrichtung 2 weist zwei, bevorzugt gleichartig ausgebildete Winkelstrebenpaare 61, 62 bzw. 71, 72 auf. Deren Schenkelpaare 61, 62 bzw. 71, 72 bestehen bevorzugt aus Profil- bzw. Rundstäben, die jeweils einen stumpfen Winkel zueinander einnehmen und nahezu im Zentrum A der Seitenfläche miteinander verbindbar sind.

Die Enden der Schenkel 61, 62 bzw. 71, 72 der beiden Winkelstrebenpaare sind jeweils in einem oberen und unteren Eckpunkt 81, 82 bzw. 91, 92 der Seitenfläche 4, 5 gelagert. Im Beispiel der FIG 1 sind die Schenkelenden in den Eckpunkten des Rahmengestelles 3 bevorzugt in Lagerblöcken 10 um die Achsen 11 und 12 schwenkbar befestigt. Im Beispiel sind diese Drehpunkte der Schenkel der Winkelstrebenpaare bevorzugt gleichzeitig die Drehpunkte der die Seitenfläche darstellenden Türflügel 4 und 5. Zur Drehlagerung können beispielsweise die Profil- bzw Rundstäbe der Schenkel 61, 62 bzw. 71, 72 der Winkelstrebenpaare an den Enden mit einem Kugelkopf versehen sein, der in dem entsprechend ausgebildende Lagerblock 10 drehbar gelagert ist.

Die Schenkel 61, 62 bzw. 71, 72 der beiden Winkelstrebenpaare verlaufen somit annähernd vom Zemtrum A der Seitenfläche 4, 5 zu deren oberen und unteren Eckpunkten 81, 82 bzw. 91, 92. Im Beispiel der FIG 1 ist das Zentrum der Seitenfläche mit einem strichpunktiert dargestellten Kreis A markiert. Dort befindet sich ein Spannverschluß 13, womit die beiden Winkelstrebenpaare bevorzugt über einen Handgriff 14 miteinander verspannbar sind. Ist gemäß der Darstellung von FIG 1 die Seitenfläche als Tür mit den Flügeln 4, 5 ausgelegt, so hat eine derartige Anordnung den Vorteil, daß mit Hilfe des Spannverschlusses 13 die Türflügel und die gesamte Seitenfläche zugleich über die Winkelstrebenpaare stabilisierend vorgespannt werden kann.

Erfindungsgemäß sind nun zusätzlich Mittel zur Längenanpassung vorgesehen, welche annähernd in diesem Zentrum A der Seitenfläche 4, 5 im Bereich des Spannverschlusses 13 angeordnet und in die Schenkel der Winkelstrebenpaare 61, 62 und 71, 72 integriert sind. Hiermit kann die Länge der einzelnen Schenkel 61, 62, 71, 72 derart angepaßt werden, daß trotz des Auftretens von Herstellungstoleranzen und/oder aufstellungsbedingten Verwindungen im Inneren des Rahmengestelles 3 eine gleichmäßige Vorspannung der Winkelstrebenpaare im Zentrum A der Seitenfläche über den Spannverschluß möglich ist. Es kann somit z.B. der Fall vermieden werden, daß die in den Diagonalen liegenden Schenkel 61, 72 bzw. 71, 62 unterschiedlich stark auf Zug beansprucht werden. Es treten zudem keinerlei Verspannungen im Inneren des Spannverschlusses 13 auf. Die Anordnung der erfindungsgemäßen Mittel zur Längenanpassung 17 annähernd im Zentrum A der Seitenfläche 4, 5 hat den weiteren Vorteil, daß diese für eine Person leicht zugänglich und somit gut bedienbar sind. Die verspannungsfreie, gleichmäßige Einstellung der Versteifungsvorrichtung 2 kann somit von einer Person auf einfache und schnelle Weise ohne jegliche weitere Hilfsmittel durch Eingriff auf die annähernd im Zentrum A der jeweiligen Seitenflächen 4, 5 liegenden Mittel zur Längenanpassung der Schenkel erreicht werden.

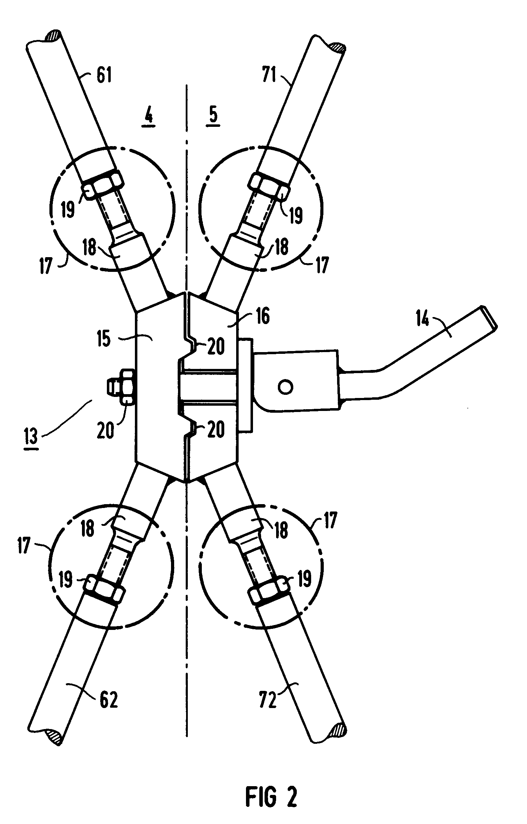

FIG 2 zeigt eine bevorzugte Ausführungsform der im Zentrum A der Seitenflächen 4, 5 liegenden Teile der erfindungsgemäßen Versteifungsvorrichtung 2 im Detail. Dabei sind erfindungsgemäß an den, auf das Zentrum A gerichteten Enden der Schenkel 61, 62 bzw. 71, 72 der Winkelstrebenpaare Mittel zur Längenanpassung 17 vorgesehen. Entsprechend dem Beispiel der FIG 2 enthalten diese bevorzugt je einen Gewindebolzen 18, welcher fest mit dem annähernd im Zentrum A der Seitenfläche liegenden Spannverschluß 13 verbunden ist. Die gegenüberliegenden Enden der bevorzugt als Rundstäbe ausgebildeten Schenkel 61, 62, 71, 72 weisen in diesem Fall bevorzugt Innengewinde auf. Sind die Rundstäbe in den Eckpunkten 81, 82, 91, 92 bevorzugt über die Lagerblöcke 10 drehbar gelagert, so können diese auf einfache Weise auf die Gewindebolzen 18 aufgeschraubt werden. Die erfindungsgemäße Vorrichtung hat somit den Vorteil, daß alle Bedien- und Einstellelemente der Versteifungsvorrichtung 2 annähernd im Zentrum A der zugehörigen Seitenfläche 4, 5 angeordnet sind. So sind gemäß der Darstellung von FIG 2 räumlich nebeneinander liegend der Handgriff 14 zur Betätigung des Spannverschlusses 13 und die Mittel zur Längenanpassung 17 am Ende des jeweiligen Schenkels 61, 62 und 71, 72 des dazu gehörigen Winkelstrebenpaares zentral und gut zugänglich angeordnet.

Vorteilhaft weisen die Mittel zur Längenanpassung 17 zusätzlich Arretiermittel auf, womit die aktuelle Längeneinstellung des jeweiligen Schenkels fixiert werden kann. Im Beispiel der FIG 2 sind hierzu Kontermuttern 19 vorgesehen.

Im Beispiel der Figuren 1 und 2 ist die Seitenfläche, welche die Versteifungsvorrichtung 2 aufweist zudem als eine zweiflügelige Tür ausgebildet. Das erste Winkelstrebenpaar mit den Schenkeln 61, 62 ist somit auf dem linken Türflügel 4 und das zweite Winkelstrebenpaar mit den Schenkeln 71, 72 auf dem rechten Türflügel 5 aufgelegt. Bevorzugt ist der Spannverschluß 13 in diesem Fall zweischalig ausgebildet. Die erste Schale 15 verbindet dabei die beiden Schenkel 61, 62 des ersten Winkelstrebenpaares auf dem ersten Türflügel 4 und die zweite Schale 16 die beiden Schenkel 71, 72 des zweiten Winkelstrebenpaares auf dem zweiten Türflügel 5 annähernd im Zentrum A der Seitenfläche.

Bevorzugt stellt jede der Schalen 15, 16 des Spannverschlusses gemeinsam mit den im stumpfen Winkel angebrachten Gewindebolzen 18 der erfindungsgemäßen Mittel zur Längenanpassung 17 einen kompakten Baukörper dar. Beiden Schalen können über einen durchgeführten Spannbolzen 20 und den darauf gelenkig gelagerten Handgriff 14 miteinander verspannt werden. Die Kontaktfläche der beiden Schalen 15, 16 liegt dabei annähernd auf den Berührungsflächen der beiden Türflügel. Im Beispiel der FIG 2 ist diese Berührungsfläche als eine strichpunktierte, zwischen den Schalen 15 und 16 des Spannverschlusses 13 hindurchgeführte Linie dargestellt. Die erfindungsgemäßen, in unmittelbarer räumlicher Nähe zum Spannverschluß 13 angeordneten Längenanpassungsmittel 17 haben den Vorteil, daß die Länge der Schenkel 61, 62, 71, 72 derart eingestellt werden kann, daß sich ein gleichmäßiger Spalt 20 zwischen den Schalen 15, 16 ergibt und diese verwindungsfrei, d.h.in annähernd paralleler Lage zueinander über den Hebel 14 verspannt werden können.

## Patentansprüche

1. Metallschrank (1) zur Aufnahme von elektrotechnischen Bauteilen, der an mindestens einer Seitenfläche (4,5) eine Versteifungsvorrichtung (2) aufweist, welche enthält
a) ein erstes und ein zweites Winkelstrebenpaar (61,62;71, 72), deren Schenkel annähernd vom Zentrum (A) zu den oberen und unteren Eckpunkten (81,91;82,92) der Seitenfläche (4,5) verlaufen,
b) einen Spannverschluß (13;14,15,16), womit die Winkelstrebenpaare (61,62;71,72) annähernd im Zentrum (A) der Seitenfläche (4,5) verspannbar sind, und
c) Mittel (17) zur Längenanpassung der Schenkel, welche annähernd im Zentrum (A) der Seitenfläche (4,5) im Bereich des Spannverschlusses (13;14,15,16) in die Schenkel der Winkelstrebenpaare (61,62;71,72) integriert sind (FIG 2).

2. Metallschrank nach Anspruch 1, **dadurch gekennzeichnet,** daß
a) die Seitenfläche als zweiflügelige Tür (4,5) ausgebildet ist,
b) das erste bzw. zweite Winkelstrebenpaar (61,62;71,72) auf dem ersten bzw. zweiten Türflügel (4;5) aufgelegt ist, und
c) der Spannverschluß (13,14) zweischalig ausgebildet ist, wobei die erste Schale (15) die beiden Schenkel (61,62) des ersten Winkelstrebenpaares auf dem ersten Türflügel (4) und die zweite Schale (16) die beiden Schenkel (71, 72) des zweiten Winkelstrebenpaares auf dem zweiten Türflügel (5) annähernd im Zentrum (A) der Seitenfläche (4,5) verbindet (Figuren 1, 2).

3. Metallschrank nach Anspruch 1 oder 2, **dadurch gekennzeichnet,** daß
a) die Mittel zur Längenanpassung (17) Gewindebolzen (18) enthalten, welche am Spannverschluß (13;14,15,16) angebracht sind, und
b) die Schenkel (61,62;91,92) der Winkelstrebenpaare
b1) in den Eckpunkten (81;82,91,92) der Seitenfläche (4,5) drehbar (10) gelagert sind, und
b2) an den gegenüberliegenden Enden Innengewinde zur Aufnahme der Gewindebolzen (18) aufweisen (FIG 2)

4. Metallschrank nach einem der vorangegangenen Ansprüche, **dadurch gekennzeichnet,** daß die Mittel zur Längenanpassung (17) Arretiermittel zur Fixierung der aktuellen Längeneinstellung aufweisen, insbesondere Kontermuttern (19).
